# EUROPÄISCHE PATENTSCHRIFT

(11) **EP 0 522 281 B1**
(45) Veröffentlichungstag und Bekanntmachung des Hinweises auf die Patenterteilung: **28.12.1994**
(21) Anmeldenummer: 92109249.0
(22) Anmeldetag: 02.06.1992
(51) Int. Cl.: H01J 37/32, H05H 1/46

(54) **Verfahren und Vorrichtung zum Zünden von CVD-Plasmen**
CVD plasma igniting procedure and device
Procédé et dispositif d'allumage de plasmas en CVD

(30) Priorität: 06.07.1991 DE 4122452
(43) Veröffentlichungstag der Anmeldung: 13.01.1993
(73) Patentinhaber: Schott Glaswerke, 55122 Mainz (DE); Carl-Zeiss-Stiftung trading as SCHOTT GLASWERKE, 55122 Mainz (DE)
(72) Erfinder: Krümmel, Harald, W-6500 Mainz 25 (DE); Mörsen, Ewald, W-6082 Mörfelden-Walldorf (DE); Paquet, Volker, W-6500 Mainz-Finthen (DE); Vogt, Helge, W-6506 Nackenheim/Rhein (DE); Weidmann, Günther, W-6509 Armsheim (DE)
(74) Vertreter: Fuchs Mehler Weiss

(56) Entgegenhaltungen:
- DE-A- 3 322 341
- GB-A- 2 077 030
- US-A- 4 175 235
- US-A- 4 888 088
- PATENT ABSTRACTS OF JAPAN vol. 14, no. 401 (E-971)30. August 1990 & JP-A-2151021

## Beschreibung

Die Erfindung betrifft ein Verfahren zum Zünden von CVD-Plasmen in einer Reaktionskammer zur Beschichtung von Substraten, bei dem ein Reaktionsgas durch die Reaktionskammer geleitet wird, in der das Plasma nach dem Zünden mittels Mikrowellenimpulsen angeregt und für eine vorgegebene Zeitspanne aufrechterhalten wird. Die Erfindung betrifft auch eine Vorrichtung zur Durchführung des Verfahrens.

Zum Beschichten von Substraten, insbesondere von Glassubstraten, werden diese in einer Beschichtungskammer einem Plasma ausgesetzt. Je nach Art der gewünschten Beschichtung werden entsprechende Reaktionsgase eingesetzt, die allerdings hinsichtlich ihrer Zündwilligkeit unterschiedlich sind. Unter Zündwilligkeit wird eine geringe Zündspannung des Gases und/oder eine geringe Löschspannung verstanden. Insbesondere Mikrowellenplasmen besitzen die Eigenschaft, daß sie sich schlecht zünden lassen, vor allem, wenn das Plasma ein Gas enthält, das als Elektronenfänger wirkt. Besonders große Zündschwierigkeiten treten bei Gasen für pulsförmige Plasmen auf, da nach jeder Impulspause das Plasma neu gezündet werden muß. Derartige Plasmen werden als PICVD-Plasmen z.B. in J.OPT.COMM.8/1987, Seite 122 ff beschrieben.

Aus der US-PS 4 888 088 ist ein Verfahren zur Zündung eines Mikrowellen-Down-Stream-Plasmas bekannt, bei dem die Reaktionsgase in einer Kammer vor der Reaktionskammer angeregt werden. Die Zündung dieses Plasmas erfolgt am gaseingangsseitige Ende der Reaktionskammer durch Einkoppelung von 1 MHz Hochspannung.

Der Einsatz von Hochfrequenz stellt eine kosteninvensive Lösung dar, weil der Anschaffungspreis der Hochfrequenzkomponenten i.a. mit der Frequenz ansteigt, für deren Anwendung sie bestimmt sind.

Die gaseingangsseitige Plazierung der Zündelektrode gemäß US-PS 4 888 088 ist für den beschriebenen Anwendungsfall nicht schädlich, kann aber bei anderen Mikrowellenbeschichtungsverfahren, wie z.B. dem PICVD-Verfahren insofern nachteilig sein, als die Reaktionsgase schon vor dem Substrat zusammengeführt und durchmischt werden. Das Zünden der Reaktionsgase im Bereich vor der Reaktionskammer führt dann zu einer Reaktion der Gase miteinander, was wiederum zur Folge hat, daß sich ein Teil der Reaktionsgase bereits vor der Reaktionskammer abscheidet. Außerdem werden undefinierte Reaktionsprodukte, z.B. Staub gebildet, der eine Trübung der auf dem Substrat aufgebrachten Schicht verursacht. Die an den Gefäßwänden durch die Teilabscheidung der Reaktionsgase aufgrund des Zündvorgangs gebildeten Schichten sind im allgemeinen schlecht haftend und blättern leicht ab, wobei sie als Partikel die Qualität der auf dem Substrat entstehenden Schichten noch zusätzlich verschlechtern.

Ein weiterer Nachteil besteht darin, daß trotz der Vorgabe des Massenflusses der Reaktionsgase eine genaue Einhaltung der Schichtdicke nicht mehr möglich ist, weil ein unbestimmter Anteil der Reaktionsgase im Bereich der Zündelektrode bei der Zündung verbraucht wird.

Aus der DE-OS 33 22 341 ist ein Verfahren und eine Vorrichtung zur Oberflächenbehandlung von Werkstücken durch Glimmentladung bekannt. Um einerseits Bogenentladungen und damit Werkstückbeschädigungen zu vermeiden und andererseits wieder Zündprobleme nicht aufkommen zu lassen, weisen die Spannungsimpulse jeweils im Anfangsbereich eine Impulsspitze zum Zünden der Glimmentladung auf und gehen anschließend in einen Bereich mit zum Aufrechterhalten der Glimmentladung geeigneter Amplitude über. Dieses Verfahren, mit dem Beschichten, Härten, Glühen und dergleichen möglich ist, unterscheidet sich von Verfahren, die mit Mikrowellenplasmen arbeiten darin, daß das Werkstück als Kathode und die das Werkstück umgebende Wandung eines Vakuumgefäßes als Anode an eine Spannungsquelle von einigen 100 bis 1000 Volt geschaltet ist. Für die Beschichtung z.B. von Glassubstraten ist dieses bekannte Verfahren jedoch nicht einsetzbar.

Aufgabe der Erfindung ist daher ein Verfahren und eine Vorrichtung zum Zünden von Mikrowellen-Plasmen, speziell für gepulste Mikrowellen-Plasmen, die wirtschaftlich ist und bei der in der Reaktionskammer keine unerwünschten Reaktionsprodukte die Qualität der Beschichtung beeinträchtigen.

Diese Aufgabe wird mit einem Verfahren gemaß den Merkmalen von Anspruch 1 und einer Vorrichtung gemäß den Merkmalen in Anspruch 12 gelöst. Eine weitere Ausführungsform der Erfindung ist Gegenstand der Ansprüche 10 und 17. Vorteilhafte Ausgestaltungen sind Gegenstand der abhängigen Ansprüche.

Es hat sich überraschend herausgestellt, daß das Plasma in der Reaktionskammer sicher von der Gasausgangsseite der Reaktionskammer gezündet werden kann, obwohl das Reaktionsgas und die angeregten Spezies nicht in Richtung der Beschichtungskammer sondern in die entgegengesetzte Richtung zur Vakuumpumpe hin bewegt werden. Gleichzeitig wird der Vorteil erreicht, daß die bei der Zündung entstehenden Reaktionsprodukte nicht in die Beschichtungskammer gelangen, sondern abgepumpt werden.

Weiterhin wurde überraschend festgestellt, daß entgegen der Empfehlung in der US-PS 4 888 088 die Frequenz des Zündgerätes nicht mindestens 1 MHz betragen muß, sondern daß eine sichere Zündung des Mikrowellenplasmas bei erheblich geringeren Frequenzen möglich ist. Für eine sichere Zündung des Mikrowellenplasmas reicht eine Hochspannung mit einer Frequenz von 10 bis 100 KHz völlig aus.

Da beim PICVD-Verfahren die Dauer der Mikrowellenimpulse für die Dicke und die Qualität der Beschichtung von ausschlaggebender Bedeutung ist, sollte beim Einsatz einer niederfrequenten Hochspannung d.h. vorzugsweise bei einer Frequenz < 30 kHz darauf geachtet werden, daß diese niederfrequente Hochspannung mit den Mikrowellenimpulsen synchronisiert ist. Wenn keine feste Phasenbeziehung zwischen der niederfrequenten Hochspannung und den Mikrowellenimpulsen gegeben ist, würde bei Verwendung einer Frequenz, deren Periodendauer nicht sehr viel kleiner ist als die Dauer des Plasmaimpulses, die unkorrelierte Zündung relativ zum Einsatz der Mikrowellenimpulse dazu führen, daß die Dauer der Impulse und damit u.U. die Qualität der pro Impuls abgeschiedenen Schicht statistisch schwankt. Die Synchronisation der niederfrequenten Hochspannung und somit die Ausbildung einer festen Phasenbeziehung zwischen der niederfrequenten Hochspannung und den Mikrowellenimpulsen gewährleistet, daß die Zündung des Plasmas bezüglich der Mikrowellenimpulse immer zum gleichen Zeitpunkt erfolgt.

Vorteilhafterweise wird die niederfrequente Hochspannung derart geschaltet, daß sie gleichzeitig mit den Mikrowellenimpulsen einsetzt. Zu diesem Zweck wird die Zündspannung ebenso wie der Mikrowellenerzeuger gepulst. Die Abschaltung der Zündung in den Impulspausen bietet hierbei den Vorteil, daß die Belegung der Gasableitung sowie der Elektroden mit einer unerwünschten Beschichtung deutlich vermindert wird.

Insbesondere für die Zündung von zündunwilligen Gasen oder von Gasen, die sehr schnell zum Verlöschen neigen, ist es von Vorteil, wenn die niederfrequente Hochspannung während der gesamten Zeitdauer der Mikrowellenimpulse aufrechterhalten wird. In diesem Fall wird nämlich während des Mikrowellenbeschichtungsimpulses das Plasma entsprechend der Frequenz des Zündgerätes immer neu gezündet. Ein Verlöschen des Plasmas während des gesamten Mikrowellenimpulses kann damit sicher verhindert werden.

Wenn eine niederfrequente Hochspannung mit Frequenzen > 30kHz verwendet wird, braucht die Hochspannung nicht mit den Mikrowellenimpulsen synchronisiert zu sein und kann während der gesamten Beschichtungsdauer eingeschaltet sein.

Gemäß einer weiteren Ausführungsform, die sich insbesondere für zündwillige Gase eignet, wird das Plasma durch mindestens einen Hochspannungsimpuls pro Mikrowellenimpuls gezündet, der ebenfalls vorteilhafterweise mit dem Mikrowellenimpuls synchronisiert ist. Bei zündwilligen Gasen reicht es aus, wenn ein einzelner kurzer Thyristorimpuls pro Mikrowellenbeschichtungsimpuls zur Zündung des Gases eingesetzt wird. Zum Zünden der Reaktionsgase werden Hochspannungsimpulse eingesetzt, deren Impulsdauer vorzugsweise im µsec-Bereich liegt.

Der Hochspannungsimpuls kann zeitgleich mit dem Mikrowellenimpuls einsetzen. Der Mikrowellenimpuls kann aber auch zeitverzögert zum Hochspannungsimpuls angelegt werden, wobei dann allerdings darauf zu achten ist, daß die Zeitverzögerung τ noch innerhalb einer Zeitspanne liegt, innerhalb derer das Plasma nach dem Zünden nicht verlöscht. Für einige Anwendungsfälle kann es auch sinnvoll sein, den Mikrowellenimpuls vor dem Hochspannungsimpuls beginnen zu lassen. Die Lage des Hochspannungsimpulses relativ zum Mikrowellenimpuls ist an sich unkritisch, wenn sichergestellt ist, daß die Zeitdauer des Mikrowellenimpulses nach der Zündung für eine einwandfreie Beschichtung ausreicht. Wie groß die Verzögerungszeit τ, die auch negativ sein kann, gewählt werden kann, hängt vom Gasdruck und von der Gasart ab. Auch die Entfernung des Ortes von der Reaktionskammer an dem die Hochspannung angelegt wird, hängt vom Gasdruck und der Gasart ab. Es wurde festgestellt, daß bis zu einer Entfernung von 50 cm von der Reaktionskammer entfernt das Gas noch sicher gezündet werden kann.

Sowohl für die niederfrequente Hochspannung als auch für die Spannungsimpulse werden Spannungen im Bereich von 5 bis 30 kV vorteilhaft eingesetzt.

Die Vorrichtung zur Durchführung des Verfahrens weist eine Reaktionskammer mit einer Gaszuleitung einer Gasableitung für das Reaktionsgas und eine Mikrowelleneinrichtung auf, die an eine Stromversorgungseinheit und an einen Taktgenerator zur Erzeugung von Mikrowellenimpulsen angeschlossen ist. Zum Zünden des Plasmas ist zusätzlich an der Gasableitung der Ausgang einer schaltbaren Hochspannungsquelle angeschlossen. Zur Übertragung der Zündhochspannung in den Gasraum wird der auf Hochspannung liegende Ausgang des Zündgerätes über ein Kabel an einer dielektrischen Wand der Gasableitung befestigt oder isoliert bei einer metallischen Wand, über eine Hochspannungsdurchführung in den Abgasstrom geführt.

Die schaltbare Hochspannungsquelle ist an den Taktgenerator angeschlossen, so daß die Synchronisation der Hochspannungsimpuse bzw. der niederfrequenten Hochspannung mit den Mikrowellenimpulsen sichergestellt ist. Die schaltbare Hochspannungsquelle ist je nach Art der gewünschten Zündung entweder zur Abgabe von Hochspannungsimpulsen oder zur Abgabe einer niederfrequenten Hochspannung ausgebildet.

Wenn der Mikrowellenimpuls zeitverzögert zur Zündhochspannung geschaltet werden soll, ist der schaltbaren Stromversorgungseinheit für die Mikrowelleneinrichtung ein einstellbares Verzögerungsglied vorgeschaltet. Für den Fall, daß der Hochspannungsimpuls zeitverzögert zum Mikrowellenimpuls anliegen soll, ist das Verzögerungsglied dementsprechend der Hochspannungsquelle vorgeschaltet.

Gemäß einer weiteren Ausführungsform kann auf eine separate Zündeinrichtung vollständig verzichtet werden, wenn der Mikrowellenimpuls soweit überhöht wird, daß die Zündspannung überschritten wird, wobei jeder Mikrowellenimpuls periodisch kurzzeitig überhöht wird, was bei Gasen mit hoher Löschspannung von Vorteil ist. Hierbei hat es sich herausgestellt, daß die überhöhten Mikrowellenimpulse eine sichere Zündung des Plasmas gewährleisten, wenn die Überhöhung das 1,1 bis etwa 10-fache der Impulshöhe beträgt, die üblicherweise beim PICVD-Verfahren zum Beschichten eingesetzt wird.

Die Vorrichtung zur Durchführung des Verfahrens sieht vor, daß die Stromversorgungseinheit für die Mikrowelleneinrichtung derart steuerbar ausgebildet ist, daß während jedes vom Taktgenerator gelieferten Impulses der an die Mikrowelleneinrichtung abgegebene Strom kurzzeitig periodisch überhöht ist. Um die Mehrzahl von Impulsüberhöhungen während der Dauer eines Mikrowellenimpulses einstellen zu können, ist die Stromversorgungseinheit vorteilhafterweise programmierbar ausgebildet. Die erste Impulsüberhöhung legt man vorteilhafterweise an den Anfang des Mikrowellenimpulses.

Damit durch die Mikrowellenimpulsüberhöhung das Substrat nicht oder nur unwesentlich aufgeheizt wird, ist die Summe der Zeitspanne t_{ü} der Mikrowellenimpulsüberhöhungen zweckmäßigerweise kleiner als 1/10 der Dauer T des Mikrowellenbeschichtungsimpulses gewählt. Bei Zündung mit einer einzigen Mikrowellenimpulsüberhöhung pro Mikrowellenbeschichtungsimpuls wird bei einem Mikrowellenbeschichtungsimpuls von z.B. 1 msec Dauer die Dauer der Impulsüberhöhung vorzugsweise auf 1 µsec begrenzt.

Beispielhafte Ausführungsformen werden nachfolgend anhand der Zeichnung näher erläutert.

Es zeigen
- Figur 1: eine schematische Darstellung der Beschichtungsanlage mit Zündeinrichtung,
- Figur 2: eine Schaltskizze der schaltbaren Hochspannungsquelle,
- Figur 3: zwei Impuls-Zeitdiagramme,
- Figur 4: Schaltskizze einer Hochspannungsquelle gemäß einer weiteren Ausführungsform,
- Figur 5: zwei Impuls-Zeitdiagramme gemäß einer weiteren Ausführungsform,
- Figur 6: eine schematische Darstellung der Beschichtungsanlage gemäß einer weiteren Ausführungsform und
- Figur 7: ein Mikrowellenimpulsdiagramm.

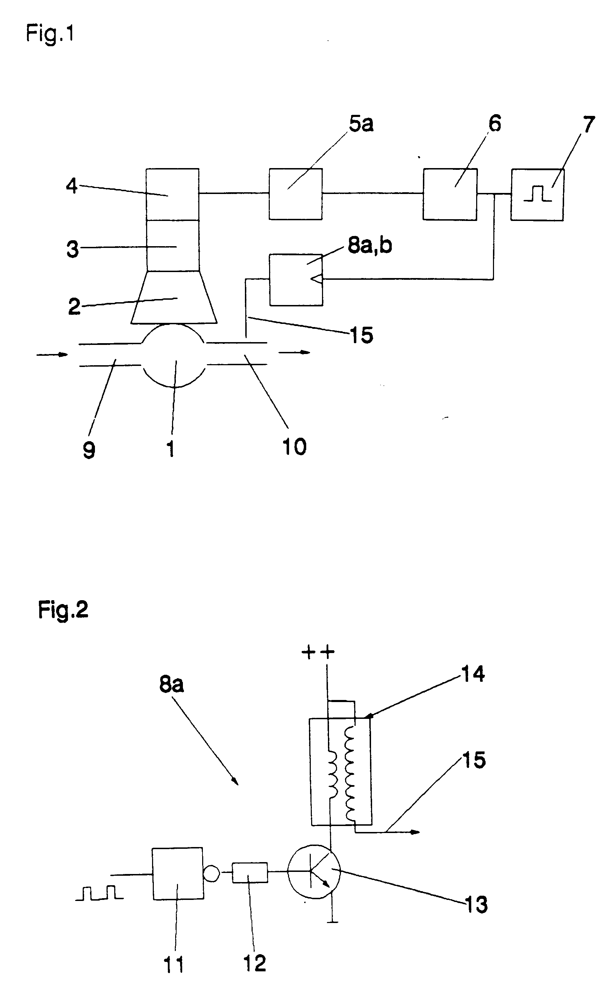

In der Figur 1 ist eine Mikrowellenbeschichtungsanlage dargestellt, die mit einer Einrichtung zum Zünden des Plasmas versehen ist. Das zu beschichtende Substrat (nicht dargestellt) befindet sich in einer Reaktionskammer 1, die über die Gaszuleitung 9 mit dem Reaktionsgas gespeist wird. Das verbrauchte Reaktionsgas wird über die Gasableitung 10 und eine daran angeschlossene Vakuumpumpe (nicht dargestellt) abgeführt. Über der Reaktionskammer 1 befindet sich die Mikrowelleneinrichtung, die eine Antenne 2, eine Abstimmeinheit 3 und eine Mikrowellenquelle 4 aufweist. Die Mikrowellenquelle ist mit einer Stromversorgung 5a verbunden, die an einen Taktgenerator 7 unter Zwischenschaltung eines Verzögerungsgliedes 6 angeschlossen ist.

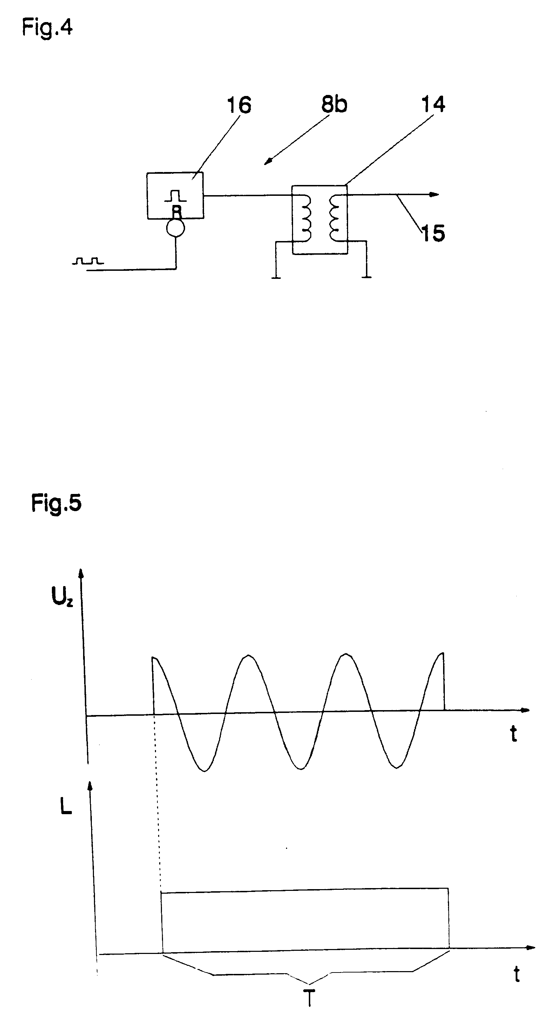

An den Ausgang des Taktgenerators 7 ist weiterhin eine schaltbare Hochspannungsquelle 8a und 8b angeschlossen, deren Hochspannungsausgang an die Gasableitung 10 angeschlossen ist. Zur Übertragung der Zündhochspannung in den Gasraum wird der auf Hochspannung liegende Ausgang des Zündgerätes 8a, 8b über ein Kabel (Hochspannungsverbindungsleitung 15) an einer dielektrischen Wand der Gasableitung 10 befestigt oder bei einer metallischen Wand isoliert über eine Hochspannungsdurchführung in den Abgasstrom geführt. Zwei verschiedene Ausführungsformen der schaltbaren Hochspannungsquelle 8a, 8b sind in der Figur 2 und in der Figur 4 näher dargestellt.

In der Figur 2 ist eine schaltbare Hochspannungsquelle 8a dargestellt, mit der einzelne Hochspannungsimpulse erzeugt werden. Das vom Taktgenerator 7 ankommenden Taktsignal durchläuft einen Inverter 11 und gelangt dann über einen Widerstand 12 zu einem Schalttransistor 13, an dessen Kollektor ein Hochspannungs-Transformator 14 angeschlossen ist. Die Verbindung zwischen der Sekundärspule des Hochspannungs-Transformators 14 und der Gasableitung 10 wird durch das Verbindungskabel 15 hergestellt.

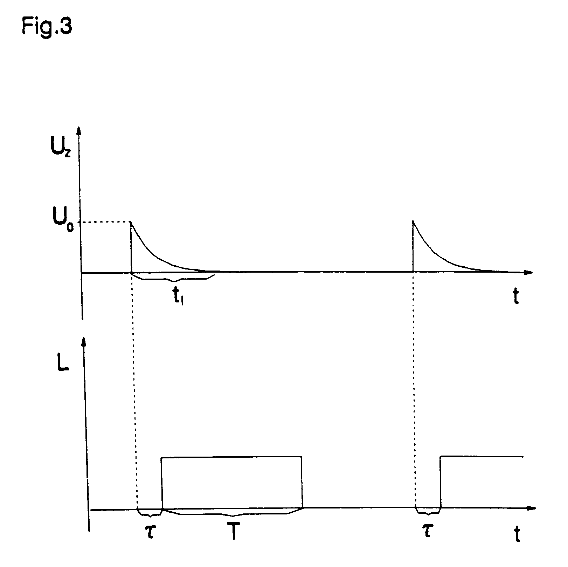

Die schaltbare Hochspannungsquelle 8a liefert am Ausgang Hochspannungsimpulse, die schematisch in Figur 3 dargestellt sind. Im oberen Diagramm ist die Hochspannung U_{z} in Abhängigkeit von der Zeit t und im unteren Diagramm die Mikrowellenleistung L in Abhängigkeit von der Zeit t aufgetragen. Die Amplitude Uₒ der Hochspannungsimpulse liegt bei ca. 5 bis 30 kV. Die Hochspannungsimpulse sind annähernd sägezahnförmig und besitzen eine Impulsdauer t_{I} von beispielsweise 1 µsec.

Da der Ausgang des Taktgenerators 7 die gleichen Impulse an die Stromversorgung 5a für die Mikrowellenquelle 4 liefert, werden zum gleichen Zeitpunkt, wie die Hochspannungsimpulse auch die Mikrowellenimpulse erzeugt. Wenn eine Zeitverzögerung τ zwischen Hochspannungsimpulsen und den Mikrowellenimpulsen gewünscht wird, so wird die gewünschte Zeitspanne an dem Verzögerungsglied 6 eingestellt. Die Verzögerungszeit τ ist in der Figur 3 so gewählt, daß der Beginn des Mikrowellenimpulses noch innerhalb des Hochspannungsimpulses liegt.

### Beispiel 1

Ein Reaktionsgas, das aus einem Teil TiCl ₄ und vier Teilen O₂ besteht, wird durch die Reaktionskammer 1 geleitet und in der Gasableitung 10 gezündet. Der Gasdruck beträgt 1 mbar. Die Zündung erfolgt mit Hochspannungsimpulsen von 15 kV. Die Abfallzeit des Hochspannungsimpulses beträgt l/e etwa 1 µsec. Die Zeitverzögerung zwischen Hochspannungsimpuls und Mikrowellenimpuls beträgt τ = 0,1 msec. Die Zeitdauer T des Mikrowellenimpulses liegt bei 1 msec, wobei die Pausenzeit zwischen den Mikrowellenimpulsen 10 msec beträgt.

In der Figur 4 ist eine weitere Ausführungsform der schaltbaren Hochspannungsquelle 8b dargestellt. Die vom Taktgenerator 7 gelieferten Impulse gelangen zunächst zu einem Frequenzgenerator 16 der im Bereich von 10 bis 100 KHz arbeitet. Der Ausgang des Frequenzgenerator 16 liegt - eventuell über einen zusätzlichen Treibertransistor - am Hochspannungstransformator 14 an, dessen Sekundärspule über die Verbindungsleitung 15 mit der Gasableitung 10 verbunden ist. Sobald ein vom Taktgenerator 7 gelieferter Impuls den Frequenzgenerator 16 erreicht, liegt an der Verbindungsleitung 15 die niederfrequente Hochspannung an.

In der Figur 5 ist im oberen Teil des Diagramms die niederfrequente Hochspannung U_{z} in Abhängigkeit von der Zeit t und darunter ein Mikrowellenimpuls (Mikrowellenleistung L in Abhängigkeit von der Zeit t) dargestellt. Die niederfrequente Hochspannung ist mit dem Mikrowellenimpuls vorzugsweise derart synchronisiert, daß bei Beginn des Mikrowellenimpulses die niederfrequente Hochspannung gerade ein Maximum durchläuft. Die niederfrequente Hochspannung wird über die gesamte Zeitdauer T des Mikrowellenimpulses aufrechterhalten. Die Zeitverzögerung τ ist in der hier gezeigten Darstellung gleich Null. Es ist jedoch auch möglich, die niederfrequente Hochspannung vor oder nach Beginn des Mikrowellenimpulses anzulegen und somit das Gas bereits vor oder nach dem Beginn des Mikrowellenimpulses zu zünden.

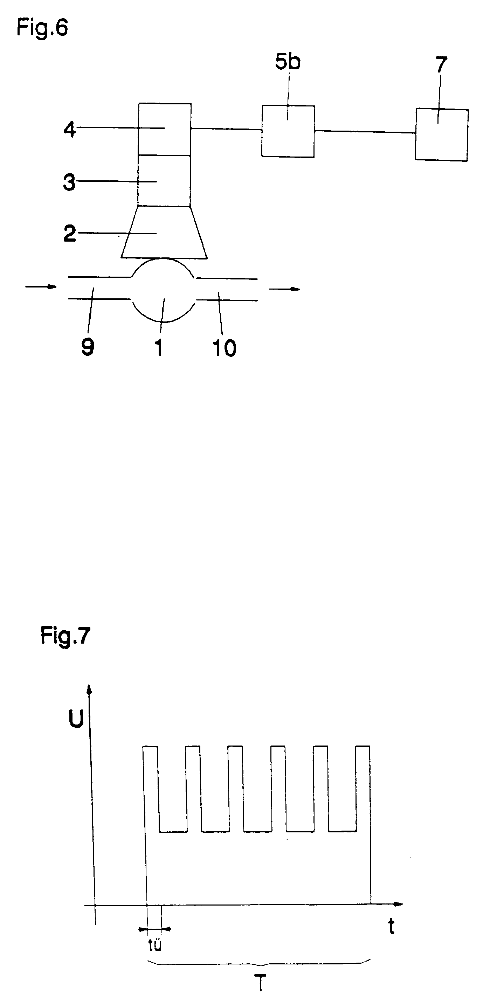

In der Figur 6 ist eine weitere Ausführungsform schematisch dargestellt. Eine separate Zündeinrichtung, die an der Gasableitung 10 angreift, ist in der hier gezeigten Anordnung entbehrlich, da die Stromversorgung 5b nicht nur vom Taktgenerator schaltbar sondern auch zusätzlich leistungssteuerbar ausgebildet ist. Die schaltbare Stromversorgung 5b ist vorzugsweise programmierbar, so daß die Mikrowellenquelle zumindest zu Beginn des Mikrowellenimpulses mit größerer Leistung versorgt wird als üblicherweise für einen Mikrowellenimpuls für den Beschichtungsvorgang erforderlich ist. Dadurch wird eine begrenzte zeitliche Impulsüberhöhung erzeugt, die zum Zünden des Gases in der Reaktionskammer 1 ausgenutzt wird. Bei zündunwilligen Gasen kann auch eine periodische Folge von Mikrowellenimpulsüberhöhungen erzeugt werden. Dieses ist insbesondere auch dann von Vorteil, wenn es sich um Gase mit hoher Löschspannung handelt (Fig. 7).

### Beispiel 2

Ein Reaktionsgas mit einem Teil TiCl₄ und vier Teilen O₂ wird durch die Reaktionskammer 1 geleitet. Der Gasdruck beträgt 1 mbar. Die Überhöhung des Mikrowellenimpulses beträgt das Zweifache des für die Beschichtung eingesetzten Mikrowellenimpulses. Die Dauer der Impulsüberhöhung liegt bei 1 µsec.

### BEZUGSZEICHENLISTE

- 1: Reaktionskammer
- 2: Antenne
- 3: Abstimmeinheit
- 4: Mikrowellenquelle
- 5a,b: Stromversorgungseinheit
- 6: Verzögerungsglied
- 7: Taktgenerator
- 8a,b: schaltbare Hochspannungsquelle
- 9: Gaszuführleitung
- 10: Gasableitung
- 11: Inverter
- 12: Widerstand
- 13: Transistor
- 14: Hochspannungs-Transformator
- 15: Hochspannungsverbindungsleitung
- 16: Frequenzgenerator

## Patentansprüche

1. Verfahren zum Zünden von CVD-Plasmen in einer Reaktionskammer zur Beschichtung von Substraten, bei dem Reaktionsgas durch die Reaktionskammer geleitet wird, in der das Plasma nach dem Zünden mittels Mikrowellenimpulsen angeregt und für eine vorgegebene Zeitspanne aufrechterhalten wird, dadurch gekennzeichnet,
daß das Plasma gasausgangsseitig der Reaktionskammer mittels einer zumindest kurzzeitig angelegten Hochspannung gezündet wird.

2. Verfahren nach Anspruch 1, dadurch gekennzeichnet, daß eine Hochspannung von 5 bis 30 kV verwendet wird.

3. Verfahren nach einem der Ansprüche 1 oder 2, dadurch gekennzeichnet, daß das Plasma durch mindestens einen Hochspannungsimpuls pro Mikrowellenimpuls gezündet wird, der mit dem Mikrowellenimpuls synchronisiert ist.

4. Verfahren nach Anspruch 3, dadurch gekennzeichnet, daß der Mikrowellenimpuls gleichzeitig oder zeitverzögert zum Hochspannungsimpuls oder vor dem Hochspannungsimpuls einsetzt.

5. Verfahren nach einem der Ansprüche 1 oder 2, dadurch gekennzeichnet, daß das Plasma durch eine niederfrequente Hochspannung gezündet wird.

6. Verfahren nach Anspruch 5, dadurch gekennzeichnet, daß die niederfrequente Hochspannung mit dem Mikrowellenimpuls synchronisiert ist.

7. Verfahren nach Anspruch 6, dadurch gekennzeichnet, daß die niederfrequente Hochspannung mit dem Mikrowellenimpuls einsetzt und zumindest für die Dauer des Mikrowellenimpulses aufrechterhalten wird.

8. Verfahren nach einem der Ansprüche 6 oder 7, dadurch gekennzeichnet, daß die niederfrequente Hochspannung in den Mikrowellenimpulspausen abgeschaltet wird.

9. Verfahren nach einem der Ansprüche 6 bis 8, dadurch gekennzeichnet, daß eine Hochspannung mit einer Frequenz von 10 - 100 kHz verwendet wird.

10. Verfahren zum Zünden von CVD-Plasmen in einer Reaktionskammer zur Beschichtung von Substraten, bei dem ein Reaktionsgas durch die Reaktionskammer geleitet wird, in der das Plasma nach dem Zünden mittels Mikrowellenimpulsen angeregt und für eine vorgegebene Zeitspanne aufrechterhalten wird, dadurch gekennzeichnet,
daß die Mikrowellenimpulse während der Dauer jedes Mikrowellenimpulses periodisch kurzzeitig überhöht werden.

11. Verfahren nach Anspruch 10, dadurch gekennzeichnet, daß die Mikrowellenimpulse um das 1,1 bis 10-fache überhöht werden.

12. Vorrichtung zur Durchführung des Verfahrens nach einem der Ansprüche 1 bis 9, mit einer Reaktionskammer mit Gaszuleitung und mit Gasableitung für das Reaktionsgas und mit einer Mikrowelleneinrichtung, die an eine Stromversorgungseinheit und an einen Taktgenerator zur Erzeugung von Mikrowellenimpulsen angeschlossen ist, dadurch gekennzeichnet,
daß an der Gasableitung (10) der Ausgang einer schaltbaren Hochspannungsquelle (8a, 8b) anliegt.

13. Vorrichtung nach Anspruch 12, dadurch gekennzeichnet, daß die schaltbare Hochspannungsquelle (8a, 8b) an den Taktgenerator (7) angeschlossen ist.

14. Vorrichtung nach Anspruch 12 oder 13, dadurch gekennzeichnet, daß der schaltbaren Stromversorgungseinheit (5a, 5b) oder der schaltbaren Hochspannungsquelle (8a, 8b) ein einstellbares Verzögerungsglied (6) vorgeschaltet ist.

15. Vorrichtung nach einem der Ansprüche 12 bis 14, dadurch gekennzeichnet, daß die schaltbare Hochspannungsquelle (8a) zur Abgabe von Hochspannungsimpulsen ausgebildet ist.

16. Vorrichtung nach einem der Ansprüche 12 bis 14, dadurch gekennzeichnet, daß die schaltbare Hochspannungsquelle (8b) zur Abgabe einer niederfrequenten Hochspannung ausgebildet ist.

17. Vorrichtung zur Durchführung des Verfahrens nach einem der Ansprüche 10 oder 11, mit einer Reaktionskammer mit Gaszuleitung und mit Gasableitung für das Reaktionsgas und mit einer Mikrowelleneinrichtung, die an eine Stromversorgungseinheit und an einen Taktgenerator zur Erzeugung von Mikrowellenimpulsen angeschlossen ist, dadurch gekennzeichnet,
daß die Stromversorgungseinheit (5b) während jedes vom Taktgenerator (7) gelieferten Impulses zur Abgabe periodisch überhöhter Ströme an die Mikrowellenquelle (4) ausgebildet ist.

## Claims

1. Process for igniting CVD plasmas in a reaction chamber for coating substrates, in which process reaction gas is passed through the reaction chamber, in which the plasma is excited after ignition by means of microwave pulses and is maintained for a predetermined period, characterized in that the plasma is ignited on the gas outlet side of the reaction chamber by means of a high voltage which is applied at least briefly.

2. Process according to Claim 1, characterized in that a high voltage of 5 to 30 kV is used.

3. Process according to either of Claims 1 or 2, characterized in that the plasma is ignited by at least one high-voltage pulse per microwave pulse which is synchronized with the microwave pulse.

4. Process according to Claim 3, characterized in that the microwave pulse begins at the same time or with a time delay with respect to the high-voltage pulse or before the high-voltage pulse.

5. Process according to either of Claims 1 or 2, characterized in that the plasma is ignited by a low-frequency high voltage.

6. Process according to Claim 5, characterized in that the low-frequency high voltage is synchronized with the microwave pulse.

7. Process according to Claim 6, characterized in that the low-frequency high voltage begins with the microwave pulse and is maintained at least for the duration of the microwave pulse.

8. Process according to either of Claims 6 or 7, characterized in that the low-frequency high voltage is switched off in the breaks between the microwave pulses.

9. Process according to one of Claims 6 to 8, characterized in that a high voltage having a frequency of 10 - 100 kHz is used.

10. Process for igniting CVD plasmas in a reaction chamber for coating substrates, in which process a reaction gas is passed through the reaction chamber, in which the plasma is excited after ignition by means of microwave pulses and is maintained for a predetermined period, characterized in that the microwave pulses are periodically briefly amplified during the duration of each microwave pulse.

11. Process according to Claim 10, characterized in that the microwave pulses are amplified by 1.1 to 10 times.

12. Apparatus for carrying out the process according to one of Claims 1 to 9, having a reaction chamber with gas incoming line and with gas outgoing line for the reaction gas and having a microwave device which is connected to a power supply unit and to a clock generator for generating microwave pulses, characterized in that the output of a switchable high-voltage source (8a, 8b) is applied to the gas outgoing line (10).

13. Apparatus according to Claim 12, characterized in that the switchable high-voltage source (8a, 8b) is connected to the clock generator (7).

14. Apparatus according to Claim 12 or 13, characterized in that an adjustable delay element (6) is arranged upstream of the switchable power supply unit (5a, 5b) or the switchable high-voltage source (8a, 8b).

15. Apparatus according to one of Claims 12 to 14, characterized in that the switchable high-voltage source (8a) is constructed to emit high-voltage pulses.

16. Apparatus according to one of Claims 12 to 14, characterized in that the switchable high-voltage source (8b) is constructed to emit a low-frequency high voltage.

17. Apparatus for carrying out the process according to either of Claims 10 or 11, having a reaction chamber with gas incoming line and with gas outgoing line for the reaction gas and having a microwave device which is connected to a power supply unit and to a clock generator for generating microwave pulses, characterized in that the power supply unit (5b) is constructed to emit periodically amplified currents to the microwave source (4) during each pulse supplied by the clock generator (7).

## Revendications

1. Procédé d'allumage de plasmas CVD dans une chambre de réaction en vue du revêtement de substrats, dans lequel on fait passer du gaz réactif à travers la chambre de réaction dans laquelle le plasma, après allumage, est excité et entretenu pendant une durée prédéterminée à l'aide d'impulsions micro-ondes, caractérisé par le fait que le plasma est allumé côté sortie de gaz de la chambre de réaction au moyen d'une haute tension appliquée au moins pendant une courte durée.

2. Procédé suivant la revendication 1, caractérisé par le fait qu'on utilise une haute tension de 5 à 30 kV.

3. Procédé suivant la revendication 1 ou 2, caractérisé par le fait que le plasma est allumé par au moins une impulsion haute tension par impulsion micro-ondes, l'impulsion haute tension étant synchronisée avec l'impulsion micro-ondes.

4. Procédé suivant la revendication 3, caractérisé par le fait que l'impulsion micro-ondes est appliquée simultanément avec, ou avec retard, par rapport à l'impulsion haute tension ou avant l'impulsion haute tension.

5. Procédé suivant la revendication 1 ou 2, caractérisé par le fait que le plasma est allumé par une haute tension de fréquence réduite.

6. Procédé suivant la revendication 5, caractérisé par le fait que la haute tension de fréquence réduite est synchronisée avec l'impulsion micro-ondes.

7. Procédé suivant la revendication 6, caractérisé par le fait que la haute tension de fréquence réduite est appliquée avec l'impulsion micro-ondes et est entretenue au moins pour la durée de l'impulsion micro-ondes.

8. Procédé suivant la revendication 6 ou 7, caractérisé par le fait que la haute tension de fréquence réduite est coupée pendant les intervalles entre les impulsions micro-ondes.

9. Procédé suivant l'une des revendications 6 à 8, caractérisé par le fait que qu'on utilise une haute tension d'une fréquence de 10 à 100 kHz.

10. Procédé pour l'allumage de plasmas CVD dans une chambre de réaction en vue du revêtement de substrats, suivant lequel on fait passer un gaz réactif à travers une chambre de réaction dans laquelle le plasma, après allumage, est excité et entretenu pendant une durée prédéterminée à l'aide d'impulsions micro-ondes, caractérisé par le fait qu'on augmente périodiquement sur une courte durée l'amplitude des impulsions micro-ondes pendant la durée de chaque impulsion micro-ondes.

11. Procédé suivant la revendication 10, caractérisé par le fait qu'on augmente l'amplitude des impulsions micro-ondes de 1,1 à 10 fois.

12. Dispositif pour la mise en oeuvre du procédé suivant l'une des revendications 1 à 9, comprenant une chambre de réaction avec arrivé de gaz et sortie de gaz pour le gaz réactif et un dispositif micro-ondes qui est relié à une unité d'alimentation en courant et à un générateur d'horloge pour la production d'impulsions micro-ondes, caractérisé par le fait que la sortie d'une source haute tension commutable (8a, 8b) est reliée à la sortie de gaz (10).

13. Dispositif suivant la revendication 12, caractérisé par le fait que la source haute tension commutable (8a, 8b) est reliée au générateur d'horloge (7).

14. Dispositif suivant la revendication 12 ou 13, caractérisé par le fait que l'unité d'alimentation en courant commutable (5a, 5b) ou la source haute tension commutable (8a, 8b) est précédée d'un élément de retard (6) réglable.

15. Dispositif suivant l'une des revendications 12 à 14, caractérisé par le fait que la source haute tension commutable (8a) est conçue pour fournir des impulsions haute tension.

16. Dispositif suivant l'une des revendications 12 à 14, caractérisé par le fait que la source haute tension commutable (8b) est conçue pour fournir une haute tension de fréquence réduite.

17. Dispositif pour la mise en oeuvre du procédé suivant l'une des revendications 10 ou 11, comprenant une chambre de réaction avec arrivée de gaz et sortie de gaz pour le gaz réactif et un dispositif micro-ondes relié à une unité d'alimentation en courant et à un générateur d'horloge pour la production d'impulsions micros-ondes, caractérisé par le fait que l'unité d'alimentation en courant (5b) est conçue pour émettre, pendant chaque impulsion fournie par le générateur d'horloge (7), des courants d'amplitude périodiquement accrue à la source micro-ondes (4).
